# FASCICULE DE BREVET EUROPEEN

(11) **EP 1 756 872 B1**
(45) Date de publication et mention de la délivrance du brevet: **18.07.2018**
(21) Numéro de dépôt: 05746854.8
(22) Date de dépôt: 04.04.2005
(51) Int. Cl.: H01L 31/101, H01L 27/144, H01L 27/146

(54) **CIRCUIT DE DETECTION PHOTONIQUE A STRUCTURE MESA**
MESASTRUKTUR-PHOTONERKENNUNGSCHALTUNG
MESA STRUCTURE PHOTON DETECTION CIRCUIT

(30) Priorité: 05.04.2004 FR 0450677
(43) Date de publication de la demande: 28.02.2007
(73) Titulaire: Commissariat à l'Énergie Atomique et aux Énergies Alternatives, 75015 Paris (FR)
(72) Inventeur: ROTHMAN, Johan, F-38000 GRENOBLE (FR)
(74) Mandataire: Ahner, Philippe
(86) Numéro de dépôt international: PCT/FR2005/050208
(87) Numéro de publication internationale: WO 2005/101512

(56) Documents cités:
- EP-A- 0 061 803
- EP-A- 0 087 842
- EP-A- 0 475 525
- EP-A- 0 747 962
- EP-A- 0 797 256
- US-A- 4 625 226
- US-A- 4 639 756
- US-A- 5 113 076
- US-A- 5 654 578
- PATENT ABSTRACTS OF JAPAN vol. 018, no. 080 (E-1505), 9 février 1994 (1994-02-09) -& JP 05 291605 A (MITSUBISHI ELECTRIC CORP), 5 novembre 1993 (1993-11-05)

## Description

### DOMAINE TECHNIQUE ET ART ANTERIEUR

L'invention présente concerne la réalisation d'un circuit de détection de rayonnement, notamment de type infra rouge, pour une longueur d'onde par exemple supérieure à 1µm.

Un tel circuit est par exemple de type photovoltaïque.

Un circuit de détection se présente sous forme d'une matrice de pixels, où chaque pixel compte au moins un photo détecteur. Dans la cas d'un détecteur multi-spectral, chaque pixel contient au moins deux photo détecteurs, sensibles à des longueurs d'onde différentes. Le circuit de lecture assemblé avec un circuit de détection forme un système de détection.

Différentes technologies peuvent être utilisées pour les photo-détecteurs, ces différentes technologies correspondant à des architectures et à des performances différentes.

Dans la détection IR, les détecteurs photovoltaïques sont parmi les techniques les plus performantes, en concurrence, principalement, avec les détecteurs bolométriques ou à multi puits quantiques (MQWIP).

Un pixel dans un circuit de détection photovoltaïque contient au moins une jonction en matériaux semi-conducteurs ayant des dopages différents, par exemple une photodiode p-n.

Le matériau semi-conducteur peut, par exemple, être de type Hg(1-x)CdxTe avec une composition adaptée pour ajuster la longueur d'onde de coupure du détecteur, *λ*_{c}.

Le circuit de détection est conçu de sorte que chaque pixel détecte le rayonnement incident sur une surface associée au pixel, ce qui impose que les photo-porteurs, créés par le rayonnement incident à l'intérieur du pixel, ne soient collectés que par la jonction associée au pixel.

Une interférence électrique se produit dans le cas où les photo-porteurs générés dans un pixel sont détectés par une jonction d'un pixel adjacent.

De manière connue, la minimisation de ces interférences électriques est assurée par la séparation physique des pixels, en gravant des tranchées autour des pixels. Chaque pixel forme dans ce cas un « mesa ».

Dans une autre approche, dite « planar », les jonctions ont une extension spatiale limitée à l'intérieur de chaque pixel, mais les pixels ne sont pas séparés physiquement par la gravure. Les interférences électriques sont dans ce cas limitées, du fait d'un phénomène de confinement, mais restent non nulles.

Dans des applications mono-spectrales ou multi-spectrales nécessitant une interférence électrique faible, il est avantageux d'utiliser des pixels en forme de mesa.

Par contre, la gravure des mesas introduit des multiples défauts qui dégradent le fonctionnement des diodes.

La dégradation est, en partie, le résultat du mauvais contrôle des propriétés électriques des surfaces des flancs des mesas. Cette mauvaise définition peut engendrer des courants de fuite et des fluctuations des propriétés optoélectroniques intra et inter-diodes.

En particulier, la région de la jonction est très sensible aux perturbations.

Les défauts introduits par la gravure sont, de manière générale, plus importants pour des jonctions définies dans des matériaux ayant des largeurs de bande interdite étroites et une longueur d'onde de coupure de valeur élevée.

Les circuits de détection de type « multi spectral », photovoltaïques, peuvent être classés en deux catégories, dépendant de la configuration des photodiodes dans les pixels.

L'approche « en série » propose d'utiliser une structure où les deux diodes d'un pixel, ayant des longueurs d'onde de coupures différentes, *λ*1 et *λ*2, par exemple *λ*1=5µm et *λ*2=10µm, sont connectées en série. Les valeurs exactes de *λ*1 et *λ*2 sont choisies en fonction de l'application du circuit de détection.

Une réalisation d'un tel composant est donnée dans le document US5113076A. Le principe général de cette approche consiste à créer deux jonctions p/n qui collectent des photo-porteurs générés dans deux matériaux semi-conducteurs avec des largeurs de bande interdite différentes, et par conséquent, des longueurs d'onde de coupure différentes. Les matériaux peuvent, par exemple, être de type Hg(1-x)CdxTe avec des compositions différentes en Cd.

Une détection avec des bandes de longueur d'ondes différentes est possible pour chaque jonction, si la structure est arrangée de sorte que la jonction, qui collecte les photo-porteurs du matériau et ayant la longueur d'onde de coupure la plus courte, *λ*1, est la plus proche de celle de la source de photons.

Dans une matrice de pixels avec les jonctions en série, les pixels sont séparés physiquement pour éviter un court-circuit électrique entre les diodes et pour que la collection de chaque jonction soit localisée. Pour ce faire, les pixels sont en général gravés en forme de mesa.

L'avantage avec l'approche « en série » est qu'il n'est nécessaire de n'utiliser qu'une interconnexion par pixel, pour lier le circuit de lecture au circuit de détection. Une densité de pixel maximale, limitée par la densité d'interconnections, est ainsi possible.

Comme pour les détecteurs mono spectraux en forme de mesa, l'inconvénient principal avec l'approche en série réside dans les défauts introduits par la gravure des mesas.

Une autre approche, dite « indépendante », propose d'utiliser un empilement des jonctions dans le pixel, où les jonctions sont connectées électriquement de façon indépendante ou partiellement indépendante.

Cette approche indépendante est caractérisée par l'utilisation de deux interconnections par pixel, qui permet de lire les deux jonctions en même temps, en cohérence temporelle. Cependant, le doublement des interconnections donne une limite de pas minimal qui est plus grande que pour l'approche en série.

### EXPOSE DE L'INVENTION

La présente invention propose une structure de pixel qui permet de réduire les problèmes introduits par la gravure, par le contrôle des propriétés électriques des surfaces des flancs des mesas. Des diodes plus reproductibles et moins défectueuses peuvent ainsi être réalisées.

L'invention permet d'améliorer les performances des photodiodes dans une matrice de pixels formant un circuit de détection de rayonnement infrarouge.

Chaque pixel contient au moins un détecteur photovoltaïque, constitué de deux régions de matériau semi-conducteur de dopage différent, formant une diode p-n.

L'absorption des photons et la création des photo-porteurs sont, de préférence, concentrés dans une des deux régions, appelée la région collectrice.

Chaque pixel contient au moins une face issue de la gravure des matériaux semi-conducteurs. Selon l'invention, pour éliminer les problèmes causés par la gravure, les faces gravées des pixels sont de dopage opposé par rapport à la région collectrice.

L'invention a tout d'abord pour objet un dispositif de détection photovoltaïque tel que défini par l'objet de la revendication 1, de type MESA, comportant au moins une première jonction, qui comporte elle - même une première couche collectrice, des flancs formés ou gravés dans cette couche collectrice, caractérisé en ce que ces flancs comportent, au moins partiellement une couche de dopage opposé au dopage de la première couche collectrice.

Par exemple, si la région collectrice est dopée p, les faces gravées sont dopées n.

Le dispositif peut aussi comporter une deuxième couche en matériau semi-conducteur, de type de dopage différent de celui de la première couche collectrice.

La couche de dopage, qui recouvre les flancs, peut alors former la première jonction avec la couche collectrice ou compléter ou prolonger cette première jonction.

Un contact électrique peut être pris sur la première couche ou sur la couche de dopage des flancs, ou sur la deuxième couche en matériau semi-conducteur, de type de dopage différent de celui de la première couche collectrice. Le dispositif selon l'invention comporte en outre une deuxième jonction, dans laquelle des flancs sont formés ou gravés.

La deuxième jonction comporte une deuxième couche collectrice.

Les flancs formés dans la deuxième jonction peuvent ne pas comporter une couche de dopage opposé au dopage de la deuxième couche collectrice ou, au contraire, comporter au moins partiellement une couche de dopage opposé au dopage de la deuxième couche collectrice.

Les deux jonctions ont de préférence des longueurs d'onde de coupure différentes.

Une couche barrière est formée ou disposée entre la première et la deuxième couche, la largeur de sa bande interdite étant supérieure aux largeurs des bandes interdites des deux couches.

Au moins une couche barrière peut être prévue sur un côté de la première couche collectrice.

Cette couche de barrière peut être en contact avec, et de même dopage que, la région collectrice.

De préférence, elle a une largeur de bande interdite plus grande que celle de la première couche collectrice.

La présence de cette barrière permet d'éviter la présence de l'extrémité d'une jonction p-n à l'interface entre un matériau avec un gap étroit et un isolant.

La barrière permet aussi, dans certaines réalisations de l'invention, de réduire les interférences électriques.

Un contact peut être pris sur la première couche collectrice à travers la couche barrière.

L'invention concerne également un procédé de réalisation d'un dispositif de détection photonique tel que défini par l'objet de la revendication 15, de type MESA, comportant :
- la formation d'au moins une première jonction, comportant elle - même une première couche collectrice,
- la formation de flancs dans cette couche collectrice, et, à la surface des flancs, d'une couche de dopage opposé au dopage de la première couche collectrice.

La jonction peut comporter en outre une deuxième couche en matériau semi-conducteur, de type de dopage différent de celui de la première couche collectrice.

Un contact peut être formé sur la première couche.

Le procédé peut en outre comporter une étape de formation d'un contact électrique avec la deuxième couche en matériau semi-conducteur.

Une étape de formation d'un contact électrique avec la couche de dopage, formée à la surface des flancs, peut également être réalisée.

L'inversion des flancs peut quant à elle être réalisée par gravure, ou par implantation ou par diffusion.

Le procédé comporte en outre la formation d'une deuxième jonction, dans au moins une deuxième couche collectrice et la formation de flancs dans cette deuxième couche collectrice, à la surface desquels une couche de dopage opposé au dopage de la deuxième couche collectrice peut être réalisée.

Une étape de formation d'une couche barrière est réalisée. Un contact électrique peut être pris avec la première couche collectrice à travers la couche barrière.

### BREVE DESCRIPTION DES FIGURES

- Les figures 1 et 3 représentent des modes de réalisation d'un dispositif non couverts par l'invention.
- Les figures 2 et 4 représentent des dispositifs connus de l'art antérieur,
- Les figures 5-8 et 11 représentent des dispositifs de type « bi-spectral » conformément à l'invention.
- Les figures 9A-10C représentent des étapes de réalisation de structures mono-spectrale et multi-spectrale.

### DESCRIPTION DE MODES PARTICULIERS DE REALISATION

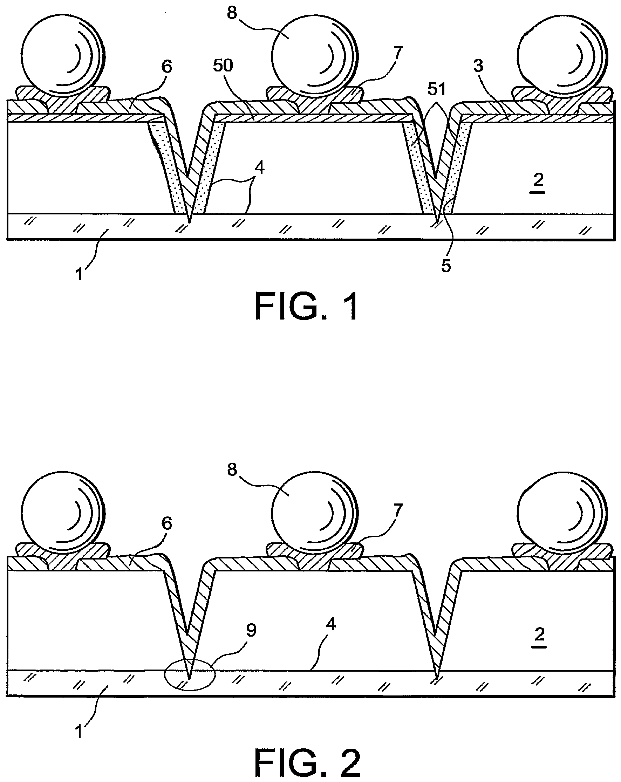

Une première réalisation mono spectrale d'un dispositif est illustrée sur la figure 1.

Dans cette réalisation, les pixels sont en forme de mesa.

Une jonction est partiellement formée entre une région collectrice dopée 2 et une couche 1 de dopage opposé à celui de la région 2, située au dessous de la région collectrice. La gravure des mesas est effectuée de manière suffisamment profonde pour déboucher dans la couche inférieure 1 : une jonction qui se termine dans l'interface gravée est mal définie, ce qui peut amener des fuites en surface ; la gravure prononcée dans la couche 1 permet d'éviter cette situation.

En effet, le dopage des faces gravées, donc des flancs 5 des mesas, étant opposé à celui de la région collectrice 2, la jonction 4 peut alors s'étendre de façon continue de la couche 1 jusqu'à la surface 50 des mesas.

L'inversion du dopage des flancs par rapport à celui de la couche 2 collectrice permet de contrôler les propriétés électriques de ces flancs et d'éliminer une éventuelle perturbation sur la collection des photo-porteurs.

Dans ce mode de réalisation, l'invention permet aussi d'éliminer la présence d'une jonction qui se termine à une interface gravée avec des propriétés électriques mal définies, telle qu'illustrée par la région encerclée 9 sur la figure 2 qui représente une structure « mésa » selon l'art antérieur. Une telle jonction peut amener des fuites entre mésas ou pixels voisins.

Une couche de barrrière 3 est, dans cette réalisation de l'invention, placée au dessus de la couche 2 collectrice, de telle façon que la jonction, formée entre les faces gravées et la région collectrice 2, se termine, en haut de la structure, dans une région formant barrière aux porteurs. Ceci évite que la jonction se termine à l'interface entre un semi-conducteur à faible gap et un isolant.

Dans le cas où la couche 2 a une composition en CdxHg(1-x)Te, par exemple avec 0,2 < x < 0,3, la région barrière 3 peut être aussi une composition en CdxHg(1-x)Te mais avec x > 0,5. Une transition progressive entre la composition de la couche 2 et de la couche barrière 3 peut même être réalisée. Une telle variation de composition modifie la valeur du gap (ou bande interdite), ce qui modifie le comportement électrique.

Les pixels sont protégés par une couche de passivation 6 et sont connectés à un circuit de lecture à travers un contact métallique 7, et une bille d'Indium 8.

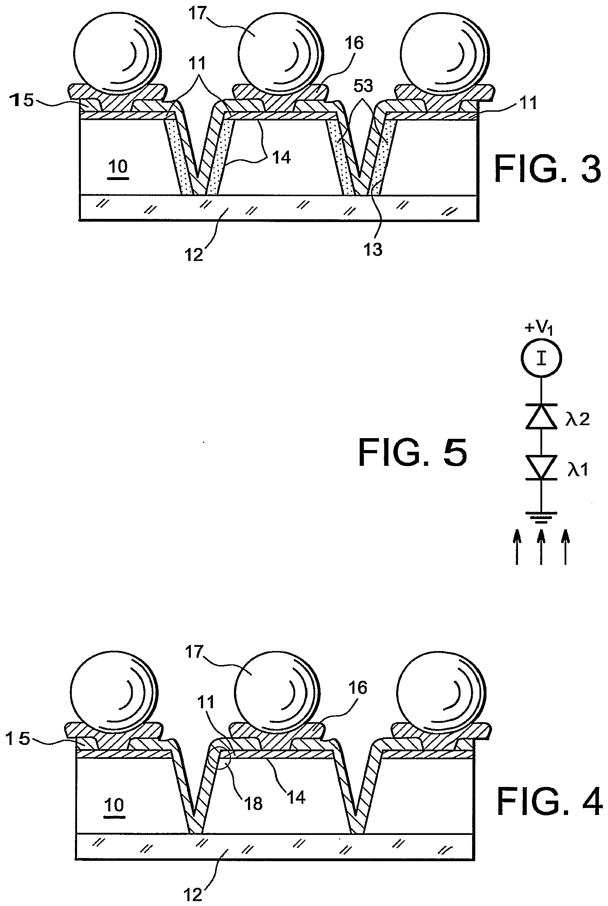

Une autre réalisation mono spectrale d'un dispositif est illustrée sur la figure 3.

Dans cette réalisation les pixels sont aussi en forme de mesa.

La jonction est partiellement formée entre une région collectrice dopée 10 et une couche 11, de type de dopage opposé au type de dopage de la région collectrice 10, située au-dessus de cette région collectrice.

La région collectrice 10 est située au dessus d'une couche barrière dopée 12, de même type de dopage que la région collectrice.

Par exemple les régions 10 et 12 sont toutes deux à base de CdxHg(1-x)Te, par exemple avec 0,2 < x < 0,3 pour la zone 10, et x > 0,5 pour la couche 12. L'effet obtenu est celui déjà indiqué ci-dessus.

La gravure des mesas est effectuée de manière suffisamment profonde pour déboucher dans la couche barrière 12.

Le dopage de la couche 53 en surface des flancs des mesas 13, est inversé par rapport au dopage de la région collectrice 10- Est ainsi formée une jonction 14 qui s'étend depuis la surface des mesas jusqu'à la couche barrière 12.

L'inversion du type de dopage des flancs 13, ou de la couche 53 située sur ces flancs, par rapport au type de dopage de la région collectrice 10, permet de contrôler les propriétés électriques des flancs et d'éliminer leur influence sur la collection des photo-porteurs.

La couche barrière 12 permet de terminer la jonction, formée entre les faces gravées 13 et la région collectrice 10, par une région avec une largeur de bande interdite élevée, moins sensible aux perturbations. Elle permet aussi de réduire les interférences électriques entre mésas ou pixels voisins.

Les pixels sont protégés par une couche de passivation 15 et sont connectés à un circuit de lecture à travers un contact métal 16, et une bille d'Indium 17.

Dans cette réalisation de la figure 3, l'invention permet aussi d'éliminer la présence d'une jonction à proximité de la gravure, tel qu'illustré par la région encerclée 18 sur la figure 4, qui correspond à un dispositif connu de l'art antérieur, dans lequel il n'y a pas d'inversion de dopage des faces gravées par rapport à la région collectrice.

Dans une réalisation bi-spectrale de l'invention, chaque pixel dans la matrice est constitué de deux photodiodes de longueurs d'onde de coupure *λ*2 et *λ*1 différentes entre elles, et connectées entre elles en configuration série têt e-bêche, selon l'approche en série.

Le schéma électrique équivalent d'un pixel bi-spectral selon l'invention est illustré sur la figure 5, représentant un pixel en configuration n-p-n, un rayonnement incident étant représenté par trois flèches.

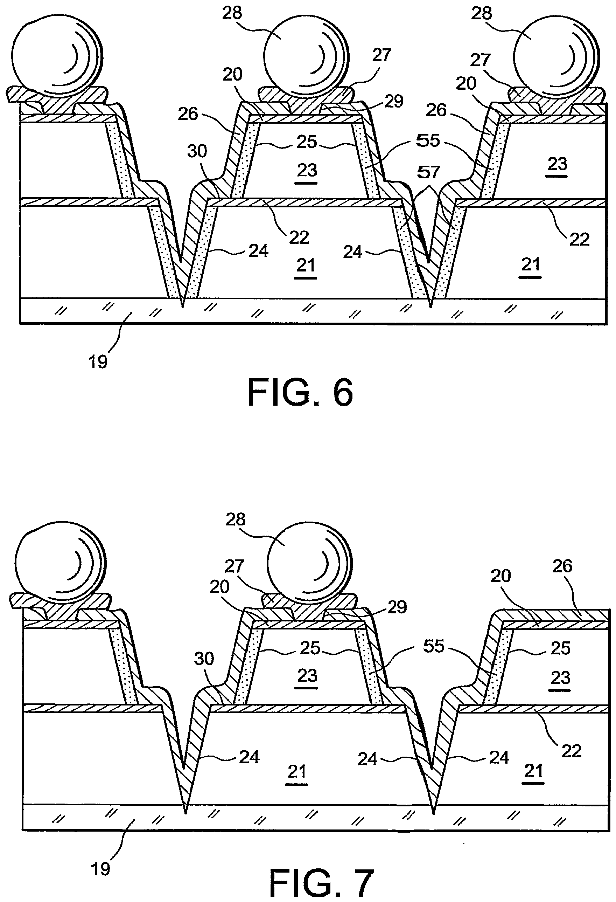

La figure 6 illustre une telle réalisation bi-spectrale de l'invention, en configuration n-p-n.

Une couche fortement dopée (ici : n+) 19 est placée en bas de la structure et est destinée à être au plus proche de la source de photons ou tournée vers cette source.

Cette couche 19 forme une première jonction p-n avec une couche 21, de type de dopage opposé à celui de la couche 19 (ici : de type p), ayant une longueur de coupure *λ*1, par exemple *λ*1=5µm, d'où provient l'essentiel de la collection des photo-porteurs de la première photodiode.

La couche 21 est séparée d'une autre couche 23, de même type de dopage que la couche 21, collectant des photo-porteurs, avec une longueur de coupure *λ*2>*λ*1, par exemple *λ*2=10µm. Cette séparation est assurée par une couche barrière 22, (ici : dopée p) et ayant un grand gap.

Une région 20, de type de dopage opposé à celui de la couche 23, forme une jonction avec cette couche 23, permettant de collecter les photo-porteurs issus d'un rayonnement d'une longueur d'onde *λ* dans une bande *λ*1<*λ*<*λ*2.

La couche de barrière 22 permet de séparer la collection des photo-porteurs des deux jonctions.

La couche 22 présente le même type de dopage que les couches 21 et 23 (donc soit n soit p), mais avec un gap plus grand que les gaps des couches 21 et 23. La couche 22 est conductrice, mais avec une barrière de potentiel (créée par le gap) permettant d'empêcher les porteurs créés dans la couche 21 (respectivement 23) d'être collectés par la couche 23 (respectivement 21).

La structure est passivée avec un isolant 26 ayant des ouvertures 29 qui permettent de prendre des contacts électriques avec la région 20 par le dépôt d'un métal 27. L'interconnexion avec un circuit de lecture se fait par exemple avec des billes d'indium 28 en contact avec le dépôt métallique 27.

Selon l'invention, on contrôle les propriétés électriques des matériaux sur les flancs 24 et 25 en inversant le dopage de ces matériaux par rapport aux régions collectrices 2L et 23.

L'inversion peut être obtenue lors de la gravure ou par implantation.

Dans la réalisation proposée en figure 6, on a ainsi deux jonctions par pixel .

Pour le pixel de la bande *λ*1, la jonction formée entre les couches 19 et 21 s'étend ainsi sur les flancs, jusqu'à la barrière 22.

Pour le pixel de la bande *λ*2, la jonction formée entre la région 20 et la couche 23 s'étend jusqu'à la barrière 22.

Les deux jonctions sont séparées par la région barrière 22, de type de dopage non inversé par rapport à celui des couches 21, 23.

Les propriétés électriques de la surface périphérique 30 de cette région non inversée sont de préférence bien contrôlées, puisque les deux jonctions sont à proximité l'une de l'autre. Ce contrôle est simplifié puisque cette zone 30 se situe dans une couche à grand gap (la couche barrière 22).

Selon l'invention, l'extension de la jonction par l'inversion des flancs permet d'obtenir un gain de performance en terme de dispersion de courants et de réduction des défauts.

Pour des pixels avec une surface gravée non inversée, la réflectivité et le piégeage des photo-porteurs varient d'un pixel à L'autre, créant ainsi de la dispersion.

Dans la présente invention, au contraire, la jonction formée par la surface inversée va collecter tous les photo-porteurs incidents sur les flancs des mesas. La dispersion en courant est donc réduite par le contrôle et par l'inversion des propriétés électriques des flancs.

L'invention permet aussi de réduire des courants de fuite qui peuvent être générés dans une structure non inversée, si la jonction s'étend jusqu'à une région où les propriétés électriques sont mal contrôlées.

Le contrôle des propriétés électriques des flancs de la diode « du bas » (jonction 19-21 sur la figure 6) est en général moins critique du fait de la plus grande stabilité des matériaux avec une longueur de coupure plus courte. L'invention concerne donc aussi un mode de réalisation où le dopage des flancs 24 de mesa de la diode « du bas » (jonction 19-21) n'est pas inversé.

Une telle réalisation est illustrée en figure 7. Cette solution permet de relâcher des contraintes sur la fabrication des pixels.

Seuls les flancs de mesa de la couche 23 sont recouverts d'une couche 25 dont le dopage est inversé par rapport à celui de cette couche 23.

Selon encore une autre réalisation bi-spectrale de l'invention on prend un contact métallique sur le flanc de mesa, évitant ainsi de former une région n, ou de dopage inversé par rapport à celui de la couche collectrice 23, en haut du mesa.

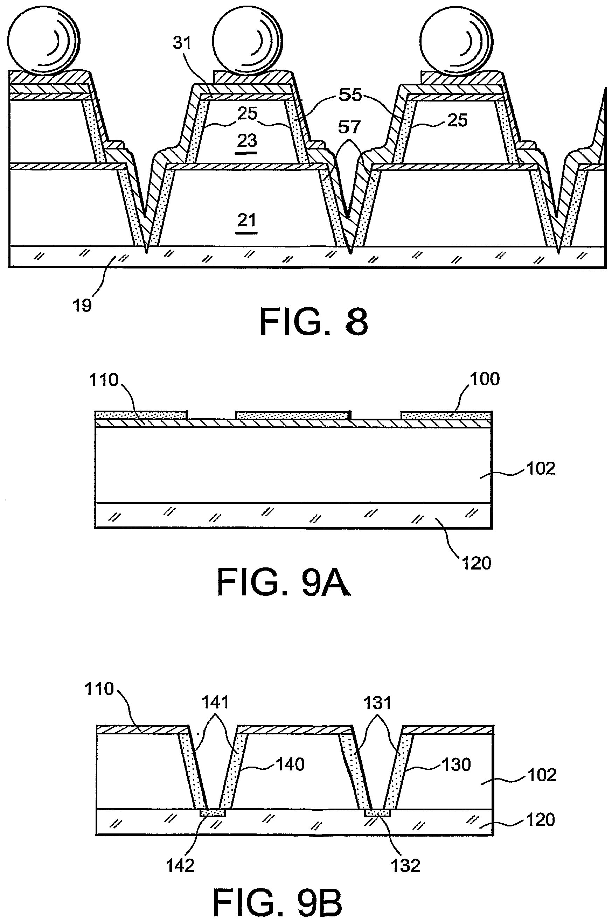

Une telle réalisation est illustrée sur la figure 8.

Dans ce cas la région 20 (dopée n dans cet exemple) de la figure 6 est remplacée par une couche barrière 31 (dopée p dans cet exemple), donc de même type de dopage que la couche collectrice 23, mais avec un gap plus important.

Par exemple, si on reprend les compositions en CdxHg(1-x)Te déjà évoquées, la couche barrière 31 pourra avoir un dopage x en Cd (par exemple avec x > 0,5) plus important que celui de la couche 23, par exemple avec 0,2 < x < 0,3.

Le contact est pris sur le flanc 25 du mesa, avec la couche 55 qui recouvre ce flanc et qui est de type de dopage inverse de celui de la couche collectrice 23 : la diode de détection est alors formée par la couche collectrice 23 et par la couche 55 qui recouvre le flanc du mésa. Ce mode de réalisation est également possible en mono spectral.

Selon encore une autre réalisation de l'invention, les dopages des différentes régions sont inversés : pour tous les modes de réalisation expliqués, on peut inverser les types de dopage indiqués pour toutes les couches.

En ce qui concerne le matériau utilisé, il peut s'agir de Hg(1-x)CdxTe.

D'autres exemples de matériaux utilisables pour des détecteurs sont les semi-conducteurs III - V (InAs(1-x)Sbx, Ga(1-x)InxSb ou Ga(1-x)InxAs(1-y)Sby) ou les semi-conducteurs de type IV - VI (Pb(1-x)SnxTe ou Pb(1-x)SnxSe).

La largeur de la bande interdite et la longueur d'onde de coupure varient en fonction de x. Dans HgxCd(1-x)Te à 77K, des compositions x = 0,225 et x=0,3 donnent des gap Eg=0,12 eV et Eg=0,24eV correspondant à des longueurs d'onde de coupure de 10 µm et 5,1µm respectivement.

La barrière peut, dans le cas de HgxCd(1-x)Te avoir une largeur de bande interdite de Eg>0,6 eV, correspondant à une composition en Cd de x>0,52.

La connexion n'est pas nécessairement par bille. On peut connecter le circuit par fil ou par adhésion moléculaire ou par toute autre technique.

Un exemple de fabrication d'un détecteur mono spectral, tel qu'illustré en figure 3, va maintenant être donné.

Les étapes de fabrications sont illustrées sur les figures 9A-9F. On remarque que ces étapes sont aussi applicables pour la réalisation des diodes du haut (la bande *λ*2, d'un détecteur bi-spectral tel qu'illustré sur les figures 6-8).

Dans la première étape (figure 9A) une résine 100 est déposée, et développée avec des tranchées, sur une hétérostructure comprenant au moins trois couches différentes : une couche barrière 120, une couche collectrice 102 et, en haut, une couche 110 de type de dopage opposé à celui de la couche collectrice 102.

La structure définie par le masque de résine est, dans une deuxième étape, transférée dans l'hétérostructure par gravure. Cette structure débouche dans la barrière 120 (figure 9B).

Si la couche collectrice 102 est de type p, la gravure peut induire une inversion du dopage des flancs 130,140 des mesas résultant, mais aussi du fond 132, 142 des tranchées dans la barrière 120.

On obtient donc des couches, en surface des flancs, dont le type de dopage est inversé par rapport au type de dopage de la couche collectrice 102.

Le résultat, après la deuxième étape, est illustré en figure 9B. L'inversion de dopage des flancs et des tranchées peut, alternativement, être induit par implantation, par exemple de bore, ou d'indium ou d'arsenic, ou par diffusion, par exemple de mercure ou de tellure.

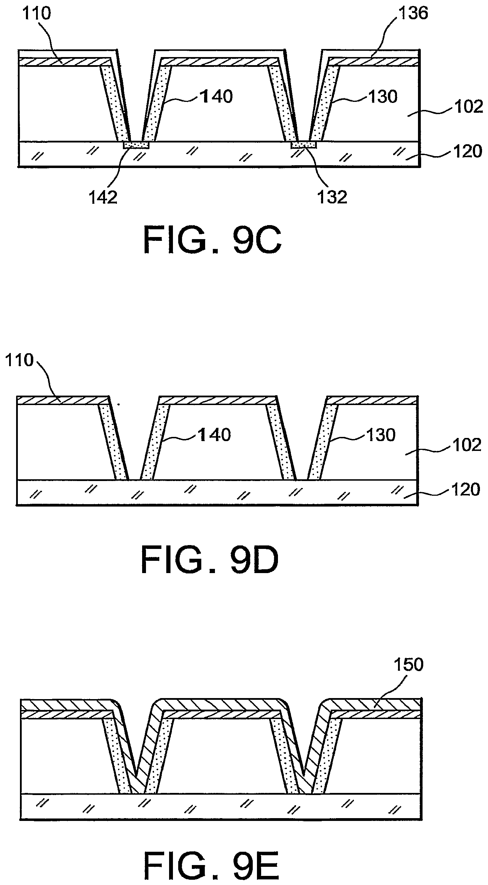

Dans une troisième étape, (comme illustré en figure 9C) une résine 136 est déposée sur l'ensemble précédemment obtenu, et développée pour graver le fond des tranchées.

Le matériau 132, 142 de dopage inversé, localisé au fond des tranchées, est ensuite enlevé par une gravure qui permet de préserver au mieux les propriétés électriques des surfaces exposées, en particulier le dopage des flancs.

La figure 9D illustre la structure après la gravure des fonds des tranchées et élimination de la résine 136.

Un dépôt d'isolant 150 permet ensuite de passiver la structure, comme illustré en figure 9E.

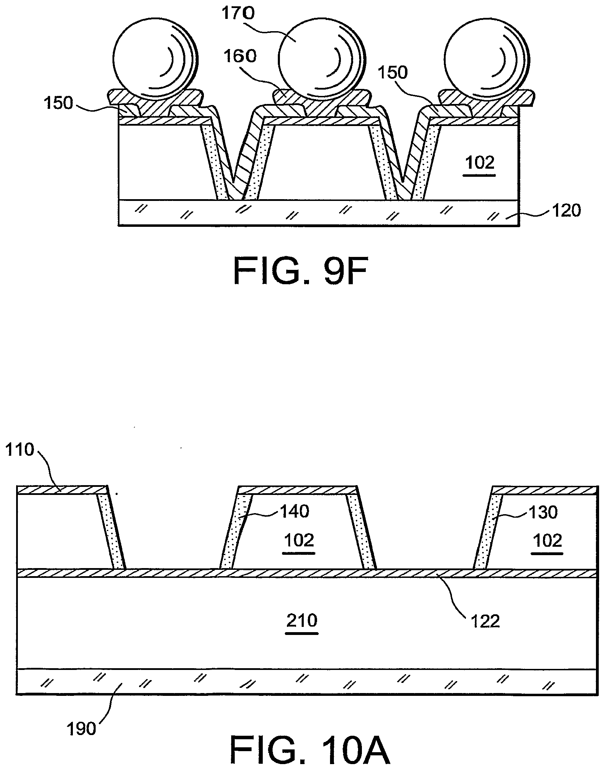

Dans une dernière étape, l'isolant 150 est ouvert pour permettre de prendre contact avec la diode par le dépôt ainsi que la structuration des contacts métalliques 160, 170 (figure 9F).

La réalisation d'un détecteur bi-spectral suit les mêmes étapes illustrées en figures 9A-9F pour fabriquer la diode de la bande *λ*2.

La figure 10A montre une structure multi-spectrale après ces étapes.

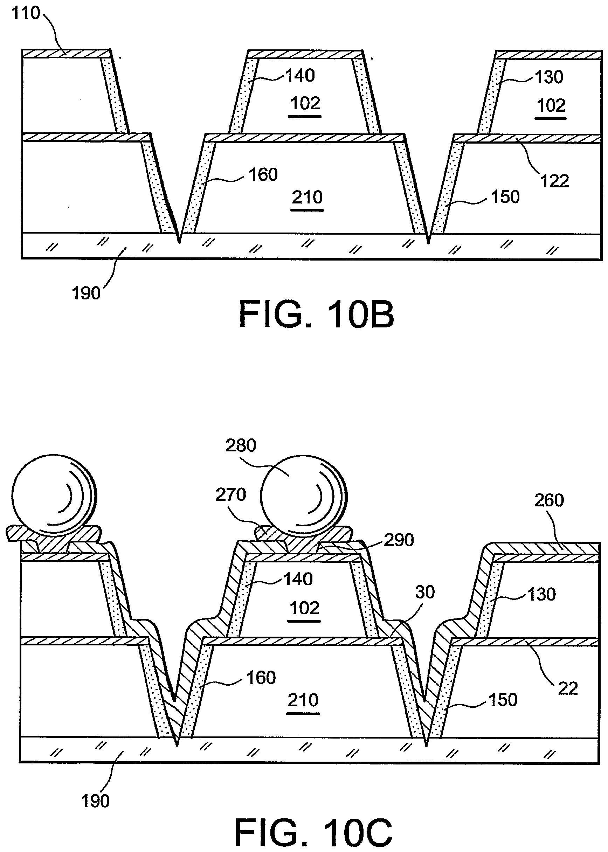

La tranchée est ensuite approfondie (figure 10B) par gravure pour déboucher dans une couche semelle 190, à travers une couche collectrice 210 en matériau semi-conducteur. La gravure est par exemple une gravure qui permet d'inverser le dopage des flancs 150, 160 des mesas de la diode du bas.

Celle -ci est formée par la couche 190 et la couche 210, qui ont des types de dopage opposés l'un de l'autre.

Les pixels sont ensuite passivés par le dépôt d'un isolant 260 (figure 10C). Une structure métallique 270 et des moyens de contact électrique tels que des billes d'indium 280 permettent la prise de contact avec les diodes de la bande *λ*2, à travers une ouverture 290 dans l'isolant (figure 10C).

Selon une variante, il est possible de réaliser des contacts électriques sur les flancs de la diode du haut, comme illustré sur la figure 8.

L'invention permet d'améliorer la performance et le rendement d'un circuit de détection de rayonnement infrarouge, constitué de pixels avec des faces gravées et avec ou moins une photodiode par pixel.

Une amélioration des performances est obtenue par inversion du dopage des faces gravées par rapport à la région collectrice et l'utilisation d'au moins une couche barrière, ce qui permet d'obtenir un ensemble de pixels plus homogène, avec moins de défauts et moins de bruit.

Dans tous les modes de réalisation de l'invention expliqués ci-dessus, des moyens d'alimentation en tension des diodes sont prévus, mais non représentés sur les figures.

De même un deuxième contact est prévu, par exemple du côté du substrat 1, 12, 19, 120, 190, le premier contact pouvant être pris, suivant le cas, soit directement sur la première couche collectrice 2, 10, 23, 102 (éventuellement à travers la couche barrière), soit sur la couche de dopage 51, 53, 55, 130, 131 recouvrant les flancs, soit sur la deuxième couche en matériau semi-conducteur 1, 11, 20 formant la première jonction avec la première couche collectrice.

L'invention propose en particulier des moyens pour réaliser un détecteur photo voltaïque bi-spectral avec deux jonctions en série, en forme de mesa, dont les propriétés électriques des flancs de mesa sont contrôlées par un dopage de type opposé aux couches collectrices dans le mesa.

Les réalisations qui ont été décrites permettent d'empêcher la terminaison des jonctions sur les flancs des mesas ou dans une région de faible gap.

L'invention permet également d'éliminer la mauvaise influence d'un état de surface mal défini sur les flancs des mesas, état de surface qui peut contribuer à une dispersion du courant photonique et du courant d'obscurité.

Le mode de réalisation de la figure 6 pose cependant le problème du décrochement entre les couches 21 et 23 de cette figure, au niveau de la couche 22.

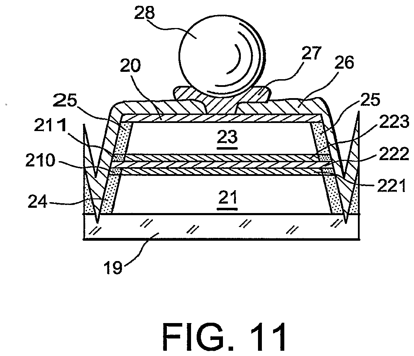

Une autre réalisation de l'invention est illustrée dans la figure 11, qui permet de résoudre ce problème.

L'isolation électrique des deux couches 21 et 23 est réalisée non pas par une séparation physique, mais par des dopages adaptés.

Plus précisément, une succession de 3 couches 221, 222, 223 remplace la couche 22.

Le gap de chacune de ces 3 couches est supérieur au gap des couches 21 et 23, le gap de la couche centrale 222 étant supérieur au gap de la couche latérale 221 et à celui de la couche latérale 223.

Le dopage des flancs 24, 25 est opposé au dopage des couches 221, 222, 223, 21 et 23 ; en valeur absolue, les dopages de ces dernières sont inférieurs au dopage des flancs 24, 25, lui - même inférieur à celui de la couche 222.

La réalisation de ce dispositif met alors en oeuvre :
- Lors d'une première étape de croissance:
   a) la réalisation d'une première couche semi conductrice 19 fortement dopée (par exemple n+), ayant de préférence un gap plus important qu'un rayonnement à détecter,
   b) la formation des deux co-uches 21 et 23 de collection de photo porteurs, de dopage opposé à celui de la couche 19 et séparées par une région barrière constituée des trois couches 221, 222, 223 de même type de dopage que les couches 21 et 23, les gaps de ces différentes couches satisfaisant les conditions relatives indiquées ci-dessus. Les couches 221 et 223 ont un niveau de dopage de même ordre de grandeur que le niveau de dopage des couches 21 et 23. La couche 222 a un niveau de dopage supérieur à celui des couches 21, 221, 223 et 23.
   c) une couche 20 de dopage opposé à celui de la couche 23. Cette couche peut aussi être créée par implantation de dopants.
- Lors d'une deuxième étape, des détecteurs individuels en forme de mesa sont ensuite formés par une seule étape de gravure. La gravure est effectué jusqu'au la couche 19.

Les flancs des mesas sont ensuite inversés électriquement pour former des régions 24, 25 de même dopage que les couches 19 et 20. L'inversion des flancs peut être effectuée par implantation ionique ou lors de l'étape de gravure.

En valeur absolue, le niveau de dopage des flancs est supérieur au niveau de dopage dans les couches 21, 221, 223 et 23, mais inférieur au niveau de dopage de la couche 222, de telle sorte que les jonctions p-n 24, 25 qui s'étendent sur les flancs de mesas s'arrêtent dans un matériau de grand gap (couches 221 ou 223 - zones 210 ou 211, respectivement), mais ne traversent pas la couche barrière 222, du fait du dopage de cette dernière.

Cette réalisation permet une mise en oeuvre plus simple de l'invention, utilisant une seule étape de gravure, ainsi qu'un alignement des motifs de gravure et une implantation moins critique.

Les mesas peuvent être encapsulés par un matériau isolant 26, permettant de stabiliser le détecteur chimiquement, électriquement et mécaniquement. Un contact électrique est finalement pris avec un dépôt métallique 27 au travers d'une ouverture dans l'isolant, permettant la connexion avec un circuit de lecture, par exemple en utilisant une bille d'indium 28.

Dans une variante, le gap des couches 221 et 223 présente un gradient, permettant d'ouvrir le gap graduellement, en passant des couche s 21 et 23 à la couche 222.

## Revendications

1. Dispositif de détection photonique, de type MESA, comportant au moins une première jonction, qui comporte elle - même une première couche collectrice (2, 10, 23, 33), des flancs (5, 13, 25, 35) formés ou gravés dans cette couche collectrice, ces flancs comportant au moins partiellement une couche (51, 53, 55, 65) de dopage opposé au dopage de la première couche collectrice, ainsi qu'une deuxième jonction (19, 21) dans laquelle des flancs sont formés ou gravés, cette deuxième jonction étant en série avec la première, la deuxième jonction comportant une deuxième couche collectrice (21, 31), la première jonction et la deuxième jonction (19, 21) étant superposées avec la première jonction sur la deuxième jonction, une couche barrière étant disposée entre la première et la deuxième couches collectrices, et la largeur de sa bande interdite étant supérieure aux largeurs des bandes interdites de ces deux couches, le dispositif photonique comprenant en outre un contact électrique.

2. Dispositif selon la revendication 1, comportant en outre une deuxième couche (1, 11, 20) en matériau semi-conducteur, de type de dopage opposé à celui de la première couche collectrice.

3. Dispositif selon la revendication 1 ou 2, la couche de dopage des flancs formant la première jonction avec la couche collectrice ou complétant ou prolongeant cette première jonction.

4. Dispositif selon l'une des revendications 1 à 3, le contact électrique étant pris soit sur la première couche collectrice, soit sur la couche (55) de dopage des flancs, soit sur la deuxième couche (1, 11, 20) en matériau semi-conducteur, de type de dopage différent de celui de la première couche collectrice.

5. Dispositif selon la revendication 1, les flancs formés dans la deuxième jonction ne comportant pas de couche (57, 67) de dopage opposé au dopage de la deuxième couche collectrice.

6. Dispositif selon la revendication 1, les flancs formés dans la deuxième jonction comportant au moins partiellement une couche (57, 67) de dopage opposé au dopage de la deuxième couche collectrice.

7. Dispositif selon l'une des revendications 1 à 6, comportant, entre les première et deuxième couches collectrices, un ensemble de 3 couches (221, 222, 223), dont une couche centrale (222) et deux couches latérales (221, 223), le gap de la couche centrale (222) étant supérieur au gap de chacune des couches latérales (221, 223), le gap de chacune de ces 3 couches étant supérieur au gap de la première et de la deuxième couches collectrices, ces 3 couches ayant un dopage opposé à celui de la couche de dopage des flancs.

8. Dispositif selon la revendication 7, le dopage des couches latérales (221, 223) et de chacune des couches collectrices (21, 23) étant inférieur au dopage des flancs, lui - même inférieur au dopage de la couche centrale (222).

9. Dispositif selon la revendication 7 ou 8, le gap des couches latérales (221, 223) présentant un gradient, permettant de d'ouvrir ou d'adapter le gap graduellement en passant des couches collectrices (21, 23) à la couche centrale (222) de l'ensemble de 3 couches situées entre ces couches collectrices.

10. Dispositif selon l'une des revendications 1 à 9, les deux jonctions ayant des longueurs d'onde de coupure différentes.

11. Dispositif selon l'une des revendications 1 à 10, comportant en outre au moins une couche barrière (3, 12, 22) sur un côté de la première couche collectrice.

12. Dispositif selon la revendication 11, la couche (3) barrière ayant une largeur de bande interdite plus grande que celle de la première couche collectrice.

13. Dispositif selon l'une des revendications 10 à 12, un contact étant pris sur la première couche collectrice à travers la couche barrière (3).

14. Dispositif selon l'une des revendications 1 à 16, comportant en outre une couche (6, 15, 26) de passivation.

15. Procédé de réalisation d'un dispositif de détection photonique, de type MESA, comportant :
- la formation d'au moins une' première jonction, comportant elle-même une première couche collectrice (102),
- la formation de flancs (130, 140) dans cette couche collectrice, et, au moins sur une partie de la surface des flancs, d'une couche (131, 141) de dopage opposé au dopage de la première couche collectrice.
- la formation d'une deuxième jonction, dans au moins une deuxième couche collectrice (210) et la formation de flancs dans cette deuxième couche collectrice, cette deuxième jonction étant en série avec la première, la première jonction et la deuxième jonction (19, 21) étant superposées avec la première jonction sur la deuxième
- la formation d'une couche barrière disposée entre la première et la deuxième couches collectrices, et la largeur de sa bande interdite étant supérieure aux largeurs des bandes interdites de ces deux couches, le procédé comprenant en outre une étape de formation d'un contact électrique.

16. Procédé selon la revendication 15, la jonction comportant en outre une deuxième couche (110, 120) en matériau semi-conducteur, de type de dopage différent de celui de la première couche collectrice.

17. Procédé selon la revendication 15 ou 16, le contact électrique est formé sur la première couche collectrice.

18. Procédé selon la revendication 15 ou 16, le contact électrique est formé sur la deuxième couche en matériau semi-conducteur.

19. Procédé selon la revendication 15 ou 16, le contact électrique est formé sur la couche de dopage formée à la surface des flancs.

20. Procédé selon l'une des revendications 15 à 19, l'inversion du dopage des flancs étant réalisée par gravure, ou par implantation ou par diffusion.

21. Procédé selon l'une des revendications 15 à 20, comportant la formation, à la surface des flancs de la deuxième couche collectrice, d'une couche (150, 160) de dopage opposé au dopage de la deuxième couche collectrice.

22. Procédé selon l'une des revendications 15 à 21, comportant en outre une étape de formation d'au moins une couche barrière sur un côté de la première couche collectrice.

23. Procédé selon la revendication 22, le contact électrique est formé sur la première couche collectrice à travers la couche barrière.

24. Procédé selon l'une des revendications 15 à 23, comportant la formation, entre les première et deuxième couches collectrices, de la région barrière comportant un ensemble de 3 couches (221, 222, 223), dont une couche centrale (222) et deux couches latérales (221, 223), le gap de la couche centrale (222) étant supérieur au gap de chacune des couches latérales (221, 223), le gap de chacune de ces 3 couches étant supérieur au gap de la première et de la deuxième couches collectrices, ces 3 couches ayant un dopage opposé à celui de la couche de dopage des flancs.

25. Procédé selon la revendication 24, le dopage des couches latérales (221, 223) et de chacune des couches collectrices (21, 23) étant inférieur au dopage des flancs, lui-même inférieur au dopage de la couche centrale (222).

## Patentansprüche

1. Vorrichtung zur Photonenerfassung vom Typ MESA, umfassend wenigstens einen ersten Übergang, der selbst wiederum eine erste Sammelschicht (2, 10, 23, 33) umfasst, Flanken (5, 13, 25, 35), die in dieser Sammelschicht gebildet oder geätzt sind, wobei diese Flanken wenigstens teilweise eine Schicht (51, 53, 55, 65) zur Dotierung entgegengesetzt zur Dotierung der ersten Sammelschicht umfassen, sowie einen zweiten Übergang (19, 21) in dem Flanken gebildet oder geätzt sind, wobei dieser zweite Übergang in Reihe mit dem ersten ist, wobei der zweite Übergang eine zweite Sammelschicht (21, 31) umfasst, wobei der erste Übergang und der zweite Übergang (19, 21) einander überlagert sind, mit dem ersten Übergang auf dem zweiten Übergang, wobei eine Barriereschicht zwischen der ersten und der zweiten Sammelschicht angeordnet ist, und wobei die Breite ihres verbotenen Bands größer ist als die Breiten der verbotenen Bänder dieser zwei Schichten, wobei die Photonenvorrichtung ferner einen elektrischen Kontakt umfasst.

2. Vorrichtung nach Anspruch 1, ferner umfassend eine zweite Schicht (1, 11, 20) aus einem Halbleitermaterial mit einem Dotierungstyp entgegengesetzt zu jenem der ersten Sammelschicht.

3. Vorrichtung nach Anspruch 1 oder 2, wobei die Dotierungsschicht der Flanken den ersten Übergang mit der Sammelschicht bildet, oder diesen ersten Übergang komplettiert oder verlängert.

4. Vorrichtung nach einem der Ansprüche 1 bis 3, wobei der elektrische Kontakt entweder auf der ersten Sammelschicht oder auf der Schicht (55) zur Dotierung der Flanken oder auf der zweiten Schicht (1, 11, 20) aus Halbleitermaterial mit einem Dotierungstyp erfolgt, der von jenem der ersten Sammelschicht verschieden ist.

5. Vorrichtung nach Anspruch 1, wobei die Flanken, die in dem zweiten Übergang gebildet sind, keine Schicht (57, 67) mit einer Dotierung entgegengesetzt zur Dotierung der zweiten Sammelschicht umfassen.

6. Vorrichtung nach Anspruch 1, wobei die Flanken, die in dem zweiten Übergang gebildet sind, wenigstens teilweise eine Schicht (57, 67) zur Dotierung entgegengesetzt zur Dotierung der zweiten Sammelschicht umfassen.

7. Vorrichtung nach einem der Ansprüche 1 bis 6, umfassend zwischen der ersten und der zweiten Sammelschicht eine Anordnung von drei Schichten (221, 222, 223), wovon eine zentrale Schicht (222) und zwei laterale Schichten (221, 223), wobei der Gap der zentralen Schicht (222) größer ist als der Gap jeder der lateralen Schichten (221, 223), wobei der Gap jeder dieser drei Schichten größer ist als der Gap der ersten und der zweiten Sammelschicht, wobei diese drei Schichten eine Dotierung entgegengesetzt zu jener der Dotierungsschicht der Flanken haben.

8. Vorrichtung nach Anspruch 7, wobei die Dotierung der lateralen Schichten (221, 223) und jeder der Sammelschichten (21, 23) geringer ist als die Dotierung der Flanken, die selbst wiederum geringer ist als die Dotierung der zentralen Schicht (222).

9. Vorrichtung nach Anspruch 7 oder 8, wobei der Gap der lateralen Schichten (221, 223) einen Gradienten aufweist, der es erlaubt, den Gap schrittweise beim Übergang von den Sammelschichten (21, 23) zur zentralen Schicht (222) der Anordnung von drei Schichten, die sich zwischen diesen Sammelschichten befinden, zu öffnen oder anzupassen.

10. Vorrichtung nach einem der Ansprüche 1 bis 9, wobei die zwei Übergänge unterschiedliche Abschneidewellenlängen haben.

11. Vorrichtung nach einem der Ansprüche 1 bis 10, ferner umfassend wenigstens eine Barriereschicht (3, 12, 22) auf einer Seite der ersten Sammelschicht.

12. Vorrichtung nach Anspruch 11, wobei die Barriereschicht (3) eine Breite des verbotenen Bands hat, die größer ist als jene der ersten Sammelschicht.

13. Vorrichtung nach einem der Ansprüche 10 bis 12, wobei ein Kontakt auf der ersten Sammelschicht durch die Barriereschicht (3) hindurch erfolgt.

14. Vorrichtung nach einem der Ansprüche 1 bis 16, ferner umfassend eine Passivierungsschicht (6, 15, 26).

15. Verfahren zur Herstellung einer Vorrichtung zur Photonenerfassung vom Typ MESA, umfassend:
- Bilden wenigstens eines ersten Übergangs, der selbst wiederum eine erste Sammelschicht (102) umfasst,
- Bilden von Flanken (130, 140) in dieser Sammelschicht und, wenigstens auf einem Teil der Oberfläche der Flanken, einer Schicht (131, 141) zur Dotierung entgegengesetzt zur Dotierung der ersten Sammelschicht,
- Bilden eines zweiten Übergangs in wenigstens einer zweiten Sammelschicht (210), und Bilden von Flanken in dieser zweiten Sammelschicht, wobei dieser zweite Übergang in Reihe mit dem ersten ist, wobei der erste Übergang und der zweite Übergang (19, 21) einander überlagert sind, mit dem ersten Übergang auf dem zweiten,
- Bilden einer Barriereschicht, die zwischen der ersten und der zweiten Sammelschicht angeordnet ist, und wobei die Breite ihres verbotenen Bands größer ist als die Breiten der verbotenen Bänder dieser zwei Schichten, wobei das Verfahren ferner einen Schritt des Bildens eines elektrischen Kontakts umfasst.

16. Verfahren nach Anspruch 15, wobei der Übergang ferner eine zweite Schicht (110, 120) aus Halbleitermaterial mit einem Dotierungstyp umfasst, der von jenem der ersten Sammelschicht verschieden ist.

17. Verfahren nach Anspruch 15 oder 16, wobei der elektrische Kontakt auf der ersten Sammelschicht gebildet ist.

18. Verfahren nach Anspruch 15 oder 16, wobei der elektrische Kontakt auf der zweiten Schicht aus Halbleitermaterial gebildet ist.

19. Verfahren nach Anspruch 15 oder 16, wobei der elektrische Kontakt auf der Dotierungsschicht gebildet ist, die auf der Oberfläche der Flanken gebildet ist.

20. Verfahren nach einem der Ansprüche 15 bis 19, wobei die Inversion der Dotierung der Flanken durch Ätzen oder durch Implantation oder durch Diffusion realisiert wird.

21. Verfahren nach einem der Ansprüche 15 bis 20, umfassend das Bilden einer Schicht (150, 160) mit einer Dotierung entgegengesetzt zur Dotierung der zweiten Sammelschicht auf der Oberfläche der Flanken der zweiten Sammelschicht.

22. Verfahren nach einem der Ansprüche 15 bis 21, ferner umfassend einen Schritt des Bildens wenigstens einer Barriereschicht auf einer Seite der ersten Sammelschicht.

23. Verfahren nach Anspruch 22, wobei der elektrische Kontakt auf der ersten Sammelschicht durch die Barriereschicht hindurch gebildet wird.

24. Verfahren nach einem der Ansprüche 15 bis 23, umfassend das Bilden, zwischen der ersten und der zweiten Sammelschicht, der Barriereregion, umfassend eine Anordnung von drei Schichten (221, 222, 223), wovon eine zentrale Schicht (222) und zwei laterale Schichten (221, 223), wobei der Gap der zentralen Schicht (222) größer ist als der Gap jeder der lateralen Schichten (221, 223), wobei der Gap jeder dieser drei Schichten größer ist als der Gap der ersten und der zweiten Sammelschicht, wobei diese drei Schichten eine Dotierung entgegengesetzt zu jener der Dotierungsschicht der Flanken haben.

25. Verfahren nach Anspruch 24, wobei die Dotierung der lateralen Schichten (221, 223) und jeder der Sammelschichten (21, 23) geringer ist als die Dotierung der Flanken, die selbst wiederum geringer ist als die Dotierung der zentralen Schichten (222).

## Claims

1. MESA-type photonic detection device comprising at least one first junction, which itself comprises a first collecting layer (2, 10, 23, 33), sides (5, 13, 25, 35) formed or etched in said collecting layer, said sides at least partially comprising a layer (51, 53, 55, 65) with a doping opposite the doping of the first collecting layer, as well as a second junction (19, 21) in which sides are formed or etched, said second junction being in series with the first one, the second junction comprising a second collecting layer (21, 31), the first junction and the second junction (19, 21) being superimposed with the first junction on the second junction, a barrier layer being placed between the first and second collecting layers, and the width of its forbidden band is greater than the widths of the forbidden bands of said two layers, the photonic device further comprising an electrical contact.

2. Device according to claim 1, also comprising a second layer (1, 11, 20) made of a semiconductor material, with the type of doping opposite that of the first collecting layer.

3. Device according to claim 1 or claim 2, the doping layer of the sides forming the first junction with the collecting layer or completing or prolonging this first junction.

4. Device according to one of claims 1 to 3, an electrical contact being formed on the first collecting layer, on the doping layer (55) of the sides, or on the second layer (1, 11, 20) of semiconductor material, with a type of doping different from that of the first collecting layer.

5. Device according to claim 1, the sides formed in the second junction not comprising a layer (57, 67) with a doping opposite the doping of the second collecting layer.

6. Device according to claim 1, the sides formed in the second junction at least partially comprising a layer (57, 67) with a doping opposite the doping of the second collecting layer.

7. Device according to one of claims 1 to 6, further comprising, between the first and second collecting layers, an assembly of 3 layers (221, 222, 223), including a central layer (222) and two lateral layers (221, 223), the gap of the central layer (222) being greater than the gap of each of the lateral layers (221, 223), the gap of each of these 3 layers being greater than the gap of the first and second of the collecting layers, said 3 layers having a doping opposite that of the doping layer of the sides.

8. Device according to claim 7, the doping of the lateral layers (221, 223) and each of the collecting layers (21, 23) being less than the doping of the sides, which is itself less than the doping of the central layer (222).

9. Device according to claim 7 or claim 8, the gap of the lateral layers (221, 223) having a gradient, making it possible to open or adapt the gap gradually by passing the collecting layers (21, 23) to the central layer (222) of the assembly of 3 layers located between these collecting layers.

10. Device according to one of claims 1 to 9, the two junctions having different cut-off wavelengths.

11. Device according to one of claims 1 to 10, further comprising at least one barrier layer (3, 12, 22) on a side of the first collecting layer.

12. Device according to claim 11, said barrier layer (3) having a forbidden bandwidth greater than that of the first collecting layer.

13. Device according to one of claims 10 to 12, a contact being formed on the first collecting layer through the barrier layer (3).

14. Device according to one of claims 1 to 13, further comprising a passivation layer (6, 15, 26).

15. Method for producing a MESA-type photonic detection device, comprising:
- the formation of at least one first junction, itself comprising a first collecting layer (102) ;
- the formation of sides (130, 140) in this collecting layer, and, at least over a portion of the surface of the sides, a layer (131, 141) with a doping opposite the doping of the first collecting layer;
- the formation of a second junction, in at least one second collecting layer (210) and the formation of sides in this second collecting layer, this second layer being in series with the first one, the first junction and the second junction (19, 21) being superimposed with the first junction on the second junction;
- the formation of a barrier layer being placed between the first and second collecting layers, and the width of its forbidden band is greater than the widths of the forbidden bands of said two layers, the method further comprising the formation of an electrical contact.

16. Method according to claim 15, the junction further comprising a second layer (110, 120) of a semiconductor material, with a type of doping different from that of the first collecting layer.

17. Method according to claim 15 or 16, the electrical contact is formed on the first collecting layer.

18. Method according to claim 15 or 16, the electrical contact is formed on the second layer of semi-conductor material.

19. Method according to claim 15 or 16, the electrical contact is formed on the doping layer formed at the surface of the sides.

20. Method according to one of claims 15 to 19, the inversion of the doping of the sides being performed by etching, by implantation or by diffusion.

21. Method according to one of claims 15 to 20, comprising the formation, at the surface of the sides of the second collecting layer, a layer (150, 160) with a doping opposite the doping of the second collecting layer.

22. Method according to one of claims 15 to 21, further comprises a step of forming at least one barrier layer on a side of the first collecting layer.

23. Method according to claim 22, further comprising a step of forming an electrical contact with the first collecting layer through the barrier layer.

24. Method according to one of claims 15 to 23, comprising the formation, between the first and second collecting layers, of a barrier region comprising an assembly of 3 layers (221, 222, 223), including a central layer (222) and two lateral layers (221, 223), the gap of the central layer (222) being greater than the gap of each of the lateral layers (221, 223), the gap of each of these 3 layers being greater than the gap of the first and second receiving layers, these 3 layers having a doping opposite that of the doping layer of the sides.

25. Method according to claim 24, the doping of the lateral layers (221, 223) and each of the receiving layers (21, 23) being less than the doping of the sides, which is itself less than the doping of the central layer (222).
